# EUROPEAN PATENT APPLICATION

(11) **EP 4 203 627 A1**
(43) Date of publication of application: **28.06.2023**
(21) Application number: 21217763.8
(22) Date of filing: 26.12.2021
(51) Int. Cl.: H05K 1/14, H05K 3/36, H05K 1/11, H05K 1/02

(54) **AUTOMOTIVE LUMINOUS DEVICE**

(71) Applicant: Valeo Vision, 93012 Bobigny Cedex (FR)
(72) Inventor: ROLDAN ZAFRA, Jose David, 23600 Martos (ES); GARCIA VIAS, Eric, 23600 Martos (ES); GOMEZ RAMIREZ, Manuel, 23600 Martos (ES); VARGAS RIZQUEZ, Jose Miguel, 23600 Martos (ES); SILES BARRIOS, Francisco Javier, 23600 Martos (ES); PARRADO LUCENA, Jose Alberto, 23600 Martos (ES); VAZQUEZ QUESADA, Rafael, 23600 Martos (ES)
(74) Representative: Valeo Visibility

(57) **Abstract**

The invention provides an automotive luminous device (10) for a signaling function, the automotive luminous device comprising a support part (3), a first substrate (1) comprising fixing means to be fixed to the support part, a second substrate (2) and an abutment part (9). The first substrate (1) comprises an electronic circuit with a first light source (4) and a first electric contact zone (5). The second substrate (2) comprises an electronic circuit with a second light source (6) and a second electric contact zone (7) faced to the first electric contact zone (5) . The abutment part (9) is different from the first substrate and is arranged to press the second substrate against the first substrate so that the first and second electric contact zones (5, 7) are electrically coupled, so that the electronic circuit of the first and second substrates (1, 2) are electrically coupled.

## Description

### TECHNICAL FIELD

This invention belongs to the field of the optical solutions for projecting light emitted by light sources of automotive luminous device outside said luminous devices.

### STATE OF THE ART

Automotive lighting market can be considered one of the most competitive ones and new lighting functionalities are constantly required.

This technical development affects basic arrangements in the lighting device, such as the arrangement of substrates for electronics (printed circuit boards, PCBs) in the luminous devices.

In some cases, an arrangement of more than one electronics substrate may be advisable, since a high amount of controlled light sources is needed, or because of size or geometry. In these cases, electrical connection and mechanical continuity of two adjacent substrates issues some problems that need to be solved.

No specific solutions have been described to face this problem, so the present invention tries to propose a new perspective to solve the aforementioned problem.

### DESCRIPTION OF THE INVENTION

The present invention provides a solution for this problem by means of an automotive luminous device. Preferred embodiments of the invention are defined in dependent claims.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

In a first inventive aspect, the invention provides an automotive luminous device for a signalling function, the automotive luminous device comprising
a support part;
a first substrate comprising fixing means to be fixed to the support part, the first substrate comprising an electronic circuit with a first light source and a first electric contact zone;
a second substrate comprising an electronic circuit with a second light source and a second electric contact zone faced to the first electric contact zone; and
an abutment part different from the first substrate arranged to press the second substrate against the first substrate so that the first and second electric contact zones are electrically coupled, so that the electronic circuit of the first and second substrates are electrically coupled.

This invention is advantageous, since it allows the use of two different substrates, such as printed circuit boards, in the design and operation of a luminous device. With the arrangement of this invention, there is no need of further soldering or welding, since the abutment part, which may perform any other functionality in the luminous device, is enough to provide the necessary pressure so that the electric circuit is closed.

The use of two different substrates may be advantageous in some cases, such as the use of a long luminous device, where a single substrate would be more expensive and difficult to control, or such as the use of different configurations in ECE and SAE, where a common arrangement may be designed for both versions and an additional substrate may be added for a version which needs any additional information. Thus, manufacturing costs are saved.

In some particular embodiments, the abutment part is a portion of a bezel.

A bezel is commonly used in automotive devices, since it provides a desired shape without any major constraints. In this case, this aesthetic function may be supplemented with the mechanical function of pressing the second substrate against the first substrate, thus achieving the technical goal without adding any more parts to the device.

In some particular embodiments, the automotive luminous device further comprises an optical part, wherein the abutment part is rigidly attached to the optical part or is a portion of the optical part.

The expression "rigidly attached" should be understood in the sense that none of the two parts which are rigidly attached may have a movement without the other part having the same movement, in the sense that they are attached with no degrees of freedom of one part with respect to the other.

In other cases, instead of using a bezel, an optical part, such as a reflector or a light guide, may be used for this purpose. Since the substrates support the light sources, which are intended to emit light that needs to be projected outside the luminous device, optical parts will be arranged very close to the substrates, so using optical supports (or portions of optical parts) as abutment parts is also advantageous.

Depending on the optical part itself, the abutment part may be a portion of the optical part or be rigidly attached to the optical part (i.e., a support of the optical part). In the event that the optical part is a reflector, the reflector usually comprises a reflector base which is leaned on the substrate. This reflector base may comprise an additional extension which may act as the abutment part. In other cases, the optical part may be a light guide. In these cases, the light guide has a light guide support, which is rigidly attached to the light guide, to provide a positioning of the same. This light guide support may have an additional extension which may act as the abutment part.

In some particular embodiments, the optical part is configured to project light emitted by the first light source. In other particular embodiments, the optical part is configured not to interfere with the light emitted by the second light source.

The abutment part, as protruding from this optical part portion or optical part support, does not interfere with the luminous functionality.

In some particular embodiments, the abutment part is configured to provide a pressure on the second substrate such that in the event the second substrate is not present, the abutment part is able to press the first substrate.

In these cases where the second substrate is only present in some of the products (ECE vs SAE, for example), it is useful that the abutment part also keeps the first substrate in place for those products which does not comprise the second substrate.

To reduce fretting corrosion risk, a contact force is established. In addition, it is also advisable to reduce the relative movement between both substrates along the substrate plane. In some particular embodiments, this is achieved by the addition of guiding pins in the support part and adding holes intended to be passed through by these pins in dedicated zones of the substrates.

In some particular embodiments, the abutment part is configured to be elastically deformed when installed in the automotive luminous device, so that pressure is exerted on the second substrate as a consequence of this elastic deformation.

This is an easy way of obtaining the pressure. The abutment part is elastically deformed when installed in place, so that the elastic recovery force acts on the substrates, creating the pressure to keep these two substrates in contact.

In some particular embodiments, the abutment part is aluminized.

In some particular embodiments, the second substrate comprises a further electric contact zone and the abutment part is intended to press the second substrate on the further electric contact zone, to provide a ground connection.

Pressure may also be used to create the ground connection for the second substrate. In this case, the number of parts is reduced, and the ground connection is effectively created.

In some particular embodiments, at least two of the electric contact zones are pads.

Pads are a good option for pressure connection, since the mere contact is enough to close the electric circuit. In some cases, a single pad is enough (e.g., for grounding metallized elements), and in other cases, at least two pads per contact zone is preferred, to provide power supply to the light sources.

In some particular embodiments, the electric contact zones comprise a finishing made of stain and/or gold and/or nickel. In some particular embodiments, the electric contact zones have a surface with a mean roughness Ra lower than 10µm.

These are good examples which combine suitable materials with smooth finishes. Although both the materials and the surface roughness have a separate effect, their combination contributes to prevent corrosion and wear more effectively.

In some particular embodiments, the support part is a heatsink.

Thus, the existing elements of the luminous device are used to perform new functionalities, there is no need to provide a separate support for providing the electric coupling between the first and second substrates.

In some particular embodiments, the second electric contact zone comprises at least two pads and the second substrate comprises at least one slot arranged between two adjacent pads.

Each slot enables the corresponding portion of the substrate to adapt to the particular height of the pads, thus improving their electric contact.

In some particular embodiments, the light sources are solid-state light sources.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows some elements of a first embodiment of an automotive luminous device according to the invention.
Figure 2 shows an assembled view of some parts of a first embodiment of a luminous device according to the invention.
Figure 3 shows some parts of a different example of a luminous device according to the invention.
Figure 4 shows a top view of some parts of an example of a luminous device according to the invention.
Figure 5 shows an embodiment of a luminous device according to the invention.

In these figures, the following reference numbers have been used:
- 1: First printed circuit board
- 2: Second printed circuit board
- 3: Heatsink
- 4: First LED
- 5: First electric contact zone
- 6: Second LED
- 7: Second electric contact zone
- 8: Electric connector
- 9: Abutment portion
- 10: Headlamp
- 11: Slot

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

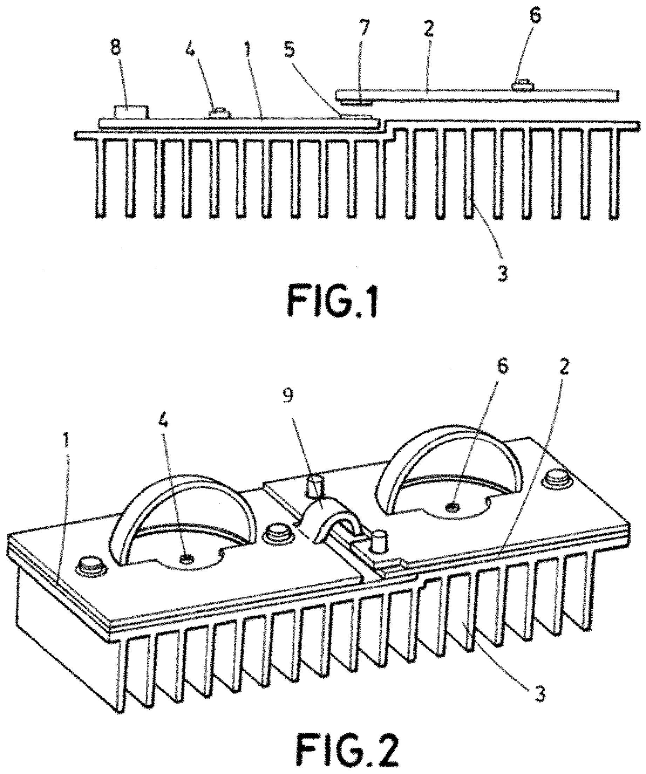

Figure 1 shows an exploded view of some elements of an automotive luminous device according to the invention. This arrangement is common to different embodiments according to the invention.

In this figure, only some elements of the invention are seen, such as a heatsink 3, a first printed circuit board 1 and a second printed circuit board 2.

The heatsink 3 is intended to be located in thermal and physical contact with the first printed circuit board 1, thus providing mechanical support to the latter.

The first printed circuit board 1 comprises an electronic circuit with a first LED 4 and a first electric contact zone 5, which in this case is a pad.

In turn, the second printed circuit board 2 comprises an electronic circuit with a second LED 6 and a second electric contact zone 7 faced to the first electric contact zone 5, which in this case is another pad.

These two pads 5, 7 comprise a finishing made of stain and/or gold and/or nickel, which is especially adapted for the pressure contact that these two pads are intended to undergo. This finishing is especially resistant to wear and ensures an optimal electric contact.

The first printed circuit board also comprises an electric connector 8, to receive electric supply. This electric supply feeds the electronic circuit of the first printed circuit board and therefore the first LED. Due to the electric connection which is established between the first printed circuit board and the second printed circuit board when the electric circuit is closed between them, the connector of the first printed circuit board is also able to feed the second printed circuit board, and therefore the second LED.

Figure 2 shows an assembled view of some parts of a first embodiment of a luminous device according to the invention.

In this figure, apart from the elements which were described in Figure 1, there are two reflectors, each reflector being arranged to project the light emitted by each one of the first and second LED.

Each one of these reflectors has a reflector base, intended to fix the reflector to the corresponding printed circuit board, and providing the necessarily accurate positioning so that the reflector projects the light emitted by the corresponding LED in the optimal direction and pattern.

The reflector base of the first reflector, apart from this functionality, also comprises an abutment protrusion 9 intended to press the second printed circuit board against the first printed circuit board. This abutment protrusion 9 is elastically deformed when installed into the luminous device, so that the elastic recovery force acts pressing the second printed circuit board against the first printed circuit board.

The first reflector is therefore used for two different functions: first one is reflecting the light emitted by the first LED, located in the first printed circuit board. Second one is pressing the second printed circuit board against the first printed circuit board. But the first reflector does not interact with the light emitted by the second LED.

The abutment protrusion, in its natural position, is configured to press on the first printed circuit board as well, thus providing a force which is enough to keep the first printed circuit board into position even in the event the second printed circuit board is not present. Thus, when the invention is used in two different designs (with the second printed circuit board and without it), the same abutment protrusion may be used for these two different purposes, without the need of further attachment parts to keep the first printed circuit board into position.

This abutment protrusion, the same as the rest of the reflector base, is aluminized, to contribute to avoid any type of corrosion.

As further seen in this figure, the second substrate comprises a further electric contact zone and the abutment protrusion is intended to press the second substrate on the further electric contact zone, to provide a ground connection.

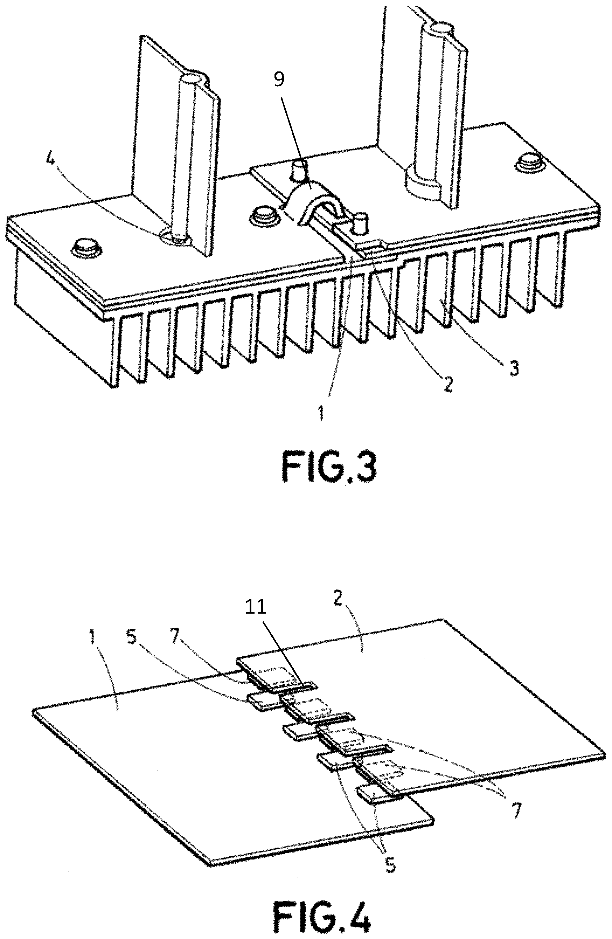

Figure 3 shows some parts of a different example of a luminous device according to the invention.

In this case, the optical element is not a reflector, but a light guide. Instead of a reflector base, there is a light guide support, which performs the same functionality as the reflector base of the previous figure: providing a firm support for the optical element (in this case, the light guide) and comprising the abutment protrusion to press on the second printed circuit board.

The rest of the properties of this second example of abutment embodiment are the same as in the preceding case: the abutment protrusion 9 is also elastically deformed to be installed over the second printed circuit board 2, the first light guide support does not interact with the light emitted by the second LED, the light guide support is also aluminized, and the abutment protrusion 9, in the rest position, may press over the first printed circuit board as well, even if the second printed circuit board is not present.

In non-illustrated embodiments, the abutment part may be a portion of a bezel, which has not a direct optical function, but is a part already present in the luminous device, and may comprise the abutment protrusion to operate in the same way as the illustrated examples.

Figure 4 shows a top view of some parts of an embodiment of a luminous device according to the invention.

In this figure, for the sake of simplicity, only the first printed circuit board 1 and the second printed circuit board 2 are illustrated. The pads which act as contact zones are represented in discontinuous trace, to show that they are hidden by the structure of the second printed circuit board 2, which is on top of the first printed circuit board.

In this figure, up to four pads are shown in each printed circuit board. Each pad of the second printed circuit board is arranged on a pad of the first printed circuit board, so the silhouettes of each pair coincide.

In some cases, due to the rigid nature of the printed circuit boards, it is easy that different heights in the pads cause that a different pressure is applied on each pair of pads. For example, if a pair of pads, due to tolerances, is 0.03 mm height and the next one is 0.025 mm high, the thicker pair would receive more pressure and the thinner pair would have a poorer electric contact.

To provide a remedy on this, a plurality of slots 11 are arranged in the second printed circuit board 2, so that, when it is pressed against the first printed circuit board, each portion between slots may adapt to the particular thickness of the pad pair. Hence, if a pad pair is thinner than the adjacent one, the slots enable the corresponding portion of the second printed circuit board to become closer, thus improving the electric contact.

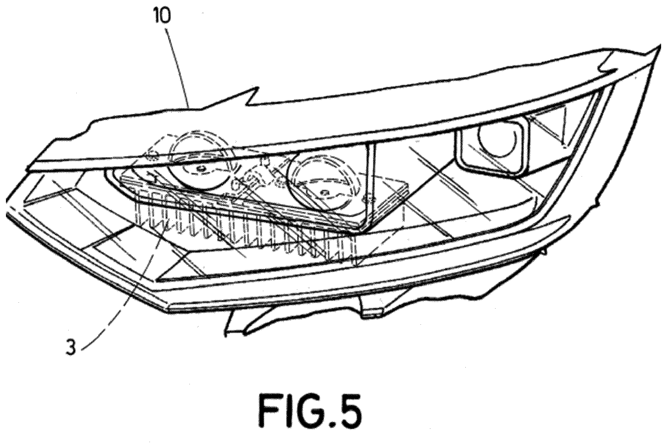

Figure 5 shows an embodiment of a luminous device according to the invention, installed in an automotive vehicle.

In this case, the invention is used for a vehicle under SAE (Society of Automotive Engineers) regulation, which requires a side light for the turning indicator. The second printed circuit board, and the second LED, is used to provide this side light, which is not required under different regulations, such as UN/ECE (United Nations Economic Commission for Europe) regulations.

## Claims

1. Automotive luminous device (10) for a signaling function, the automotive luminous device comprising
a support part (3);
a first substrate (1) comprising fixing means to be fixed to the support part, the first substrate (1) comprising an electronic circuit with a first light source (4) and a first electric contact zone (5);
a second substrate (2) comprising an electronic circuit with a second light source (6) and a second electric contact zone (7) faced to the first electric contact zone (5); and
an abutment part (9) different from the first substrate (1) arranged to press the second substrate (2) against the first substrate (1) so that the first (5) and second (7) electric contact zones are electrically coupled, so that the electronic circuit of the first and second substrates are electrically coupled.

2. Automotive luminous device (10) according to claim 1, wherein the abutment part is a portion of a bezel.

3. Automotive luminous device (10) according to claim 1, further comprising an optical part, wherein the abutment part (9) is rigidly attached to the optical part or is a portion of the optical part.

4. Automotive luminous device (10) according to claim 3, wherein the optical part comprises a reflector or a light guide.

5. Automotive luminous device (10) according to any of claims 3 or 4, wherein the optical part is configured to project light emitted by the first light source.

6. Automotive luminous device (10) according to any of claims 3 to 5, wherein the optical part is configured not to interfere with the light emitted by the second light source.

7. Automotive luminous device (10) according to any of the preceding claims, wherein the abutment part is configured to provide a pressure on the second substrate such that in the event the second substrate is not present, the abutment part is able to press the first substrate.

8. Automotive luminous device (10) according to any of the preceding claims, wherein the abutment part is configured to be elastically deformed when installed in the automotive luminous device, so that the pressure is exerted as a consequence of this elastic deformation.

9. Automotive luminous device (10) according to any of the preceding claims, wherein the abutment part is aluminized.

10. Automotive luminous device (10) according to any of the preceding claims, wherein the second substrate comprises a further electric contact zone and the abutment part is intended to press the second substrate on the further electric contact zone, to provide a ground connection.

11. Automotive luminous device (10) according to any of the preceding claims, wherein at least two of the electric contact zones (5, 7) are pads.

12. Automotive luminous device (10) according to any of the preceding claims, wherein the electric contact zones comprise a finishing made of stain and/or gold and/or nickel.

13. Automotive luminous device (10) according to any of the preceding claims, wherein the support part (3) is a heatsink.

14. Automotive luminous device (10) according to any of the preceding claims, wherein the second electric contact zone comprises at least two pads and the second substrate comprises at least one slot (11) arranged between two adjacent pads.

15. Automotive luminous device (10) according to any of the preceding claims, wherein the light sources are solid-state light sources.
